# EUROPÄISCHE PATENTSCHRIFT

(11) **EP 0 635 906 B1**
(45) Veröffentlichungstag und Bekanntmachung des Hinweises auf die Patenterteilung: **30.09.1998**
(21) Anmeldenummer: 94110633.8
(22) Anmeldetag: 08.07.1994
(51) Int. Cl.: H01R 13/658, H05K 7/00, H05K 9/00

(54) **Abgeschirmtes Gehäuse für ein Verteilerfeld**
Shielded housing for distribution assembly
Boîtier blindé pour tableau de distribution

(30) Priorität: 23.07.1993 DE 4324798
(43) Veröffentlichungstag der Anmeldung: 25.01.1995
(60) Teilanmeldung: 97122019.9
(73) Patentinhaber: TKM Telekommunikation und Elektronik GmbH, 41236 Mönchengladbach (DE)
(72) Erfinder: Gerlach, Bernd, D-64297 Darmstadt (DE)
(74) Vertreter: Meyer, Ludgerus A., Dipl.-Ing.

(56) Entgegenhaltungen:
- EP-A- 0 488 099
- DE-U- 8 002 728
- DE-U- 9 202 912
- DE-U- 9 217 572

## Beschreibung

Die Erfindung betrifft ein abgeschirmtes Gehäuse für ein Verteilerfeld und ein Verfahren zur Montage einer Reihe von abgeschirmten Kabeln in einem solchen Gehäuse.

Hohe Übertragungsraten in der modernen Datentechnik erfordern hoch abgeschirmte Kabel und immer stärker hochgeschirmte Verteilergehäuse. Da beispielsweise bis 24 Kabel mit verschiedenen Durchmessern oder verschiedenen Abschirmungsmethoden, z. B. Folienschirmung oder Geflechtschirmung im Handel sind, ist eine ausreichende Schirmung nur schwer zu realisieren.

Übliche hochgeschirmte Verteilerfelder, z. B. für RJ 45-Verteilerfelder im modularen Aufbau sind beispielsweise als 19-Zoll-Gehäuse ausgebildet, wobei sie ein geschlossenes Gehäuse mit einer vorderseitigen Anschlußreihe von RJ-45 Buchsen versehen sind. Die Kabel werden von der Rückseite des Gehäuses durch Kabeldurchführungen in das Innere geführt und dort mit Anschlußklemmen der Buchsen verbunden.

Aus dem DE-GM 80 02 728 ist ein Abschirmgehäuse für eine elektrische Schaltung bekannt, das von einem Außengehäuse umgeben ist. In das Abschirmgehäuse sind Kabel einführbar, die nebeneinanderliegend mit Anschlußklemmen im Abschirmgehäuse verbindbar sind. Die Kabelabschirmung der einzuführenden Kabel ist elektrisch leitend mit dem Abschirmgehäuse verbindbar.

Aus dem DE-GM 92 02 912 ist ein elektrische Buchsen aufweisender geschirmter Frontabschluß für Gehäuse bekannt. Die nebeneinanderliegenden Kabel sind mit Anschlußklemmen im Gehäuse verbindbar. Zur Befestigung der Kabel ist innerhalb des Gehäuses eine Montageplatte mit Befestigungsmitteln vorgesehen.

Die Schirmeigenschaften der vorgenannten Ausführungen sind für hohe Anforderungen jedoch nicht ausreichend.

Der Erfindung liegt die Aufgabe zugrunde, ein abgeschirmtes Gehäuse für ein Verteilerfeld anzugeben, dessen Schirmeigenschaften bei einfacher Montage und Handhabung weiter verbessert sind und ein Verfahren zur Montage einer Reihe von abgeschirmtem Kabeln in einem solchen Gehäuse anzugeben.

Diese Aufgabe wird durch die inden Ansprüchen 1 und 7 angegebene Erfindung gelöst. Vorteilhafte Weiterbildungen der Erfindung sind in Unteransprüchen angegeben.

Erfindungsgemäß ist innerhalb des Außengehäuses eine Montageplatte mit Befestigungsmitteln zur Befestigung der Kabel und der Anschlußklemmen vorgesehen, auf die innerhalb des Außengehäuses ein die Kabel, die Anschlußklemmen und die Montageplatte abdeckendes Abdeckgehäuse aufsetzbar ist, wobei Abdeckgehäuse und Montageplatte ein im wesentlichen geschlossenes inneres Schirmgehäuse bilden und die Kabel zwischen einem Rand des Abdeckgehäuses und der Montageplatte hindurchgeführt sind.

Trotz der zusätzlichen Schirmung des Verteilerfeldes gestaltet sich die Montage einfach, da lediglich ein Abdeckgehäuse auf die pultartige Montageplatte aufzusetzen ist.

Vorzugsweise weist das Abdeckgehäuse an seinem den Kabeln zugewandten Rand Kontaktfedem zur Kontaktierung der freigelegten Kabelabschirmungen auf. Beispielsweise können die Kontaktfedern als Abkantung des Abdeckgehäuses ausgebildet sein, wobei der abgekantete Bereich kammförmig geschnitten ist. Die so gebildeten Kontaktfedern liegen dabei im wesentlichen parallel zur Montageplatte und drücken bei Aufsetzen der Abdeckplatte auf die Kabel. Im Bereich zwischen den Kabeln bilden die Kontaktfedern Kontaktierungen mit der Montageplatte. Die Kontaktierung des Abdeckgehäuses mit den Abschirmungen der Kabel ergibt sich damit selbsttätig beim Aufsetzen des Abdeckgehäuses auf die Montageplatte.

Die Kontaktfedern befinden sich vorzugsweise im Schrägbereich der pultartig ausgebildeten Montageplatte. Dadurch wird die Kabelführung erleichtert und die Kabelklemmung am Außengehäuse gestaltet sich einfach.

Die bei abgeschirmten Kabeln vorhandenen Beidrähte können auf einfache Weise mit der Montageplatte verbunden werden. Zu diesem Zweck weist die Montageplatte vorzugsweise U-förmige Stanzzungen auf, die im spitzen Winkel zur Montageplatte gegen die Kabel gerichtet sind. Die Stanzzungen befinden sich dabei unterhalb der zu bestigenden Kabel. Die Beidrähte werden dazu um die Stanzzunge gewickelt, wobei sie sich nach dem Festlegen des Kabels und dem damit verbundenen Zurückdrücken der Stanzzungen in ihre Ausgangsstellung festklemmen. Diese Anordnung weist den Vorteil auf, daß zur Befestigung der Beidrähte keine zusätzlichen Klemmen erforderlich sind.

Die Montage des Verteilerfeldes gestaltet sich beispielsweise folgendermaßen: zunächst werden die Kabel auf eine gewisse Länge von der Außenisolierung befreit. Dann werden die Kabel auf dem ebenen vorderen Bereich der Montageplatte mittels Klemmen befestigt. Die einzelnen Leiter der Kabel können dann an Anschlußklemmen einer Buchse, insbesondere RJ-45 Buchse, befestigt werden. Der Beidraht des Kabels wird um die Ausstanzung im Schrägbereich der Montageplatte gelegt. Wenn das Kabel dann niedergedrückt wird, wird die Stanzzunge in die Ursprungsstellung zurückgedrückt und klemmt damit den Beidraht ein. Danach wird das Schirmgehäuse auf die Montageplatte aufgesetzt, wobei die Kontaktfedern des Schirmgehäuses auf den Abschirmungen der Kabel zu liegen kommen, bzw. unmittelbaren Kontakt mit der Montageplatte erhalten. Nach Schließen des Außengehäuses und Festlegung der Kabelzugentlastung ist das Verteilerfeld komplett aufgebaut.

Die erfindungsgemäße Ausbildung des Verteilerfeldes erlaubt in allen Bereichen eine Kontaktierung mit den eingeführten Kabeln, den entsprechenden Kontaktbuchsen und der Montageplatte. Trotz des zusätzlichen Schirmgehäuses ist das Verteilerfeld montagefreundlich, schnell zu montieren und kostengünstig herstellbar. Es ergibt sich nur eine sehr geringe Anzahl von Teilen.

Auch im unbelegten Zustand von Anschlußklemmen ergibt sich ein ständiger Erdungskontakt des Schirmgehäuses. Sobald Kabel eingeführt sind, werden die Zungen hochgedrückt und pressen auf die Erdungsummantelung des Kabels.

Aufgrund der vorzugsweisen pultartigen Anordnung der Montageplatte können Kabelreste, die bei den Anschlußarbeiten der Kabel entstehen können, sich nur im hinteren Bereich des Gehäuses sammeln, so daß die Gefahr von Kurzschlüssen vermieden ist.

Die Erfindung wird nachstehend anhand eines Ausführungsbeispiels näher erläutert. Es zeigen
- Fig. 1:: eine teilweise weggebrochene perspektivische Ansicht eines Verteilerkreises nach der Erfindung
- Fig. 2:: eine Schnittansicht einer ersten Ausführungsform
- Fig. 3:: eine Schnittansicht einer zweiten Ausführungsform und
- Fig. 4:: eine Schnittansicht einer dritten Ausführungsform der Erfindung.

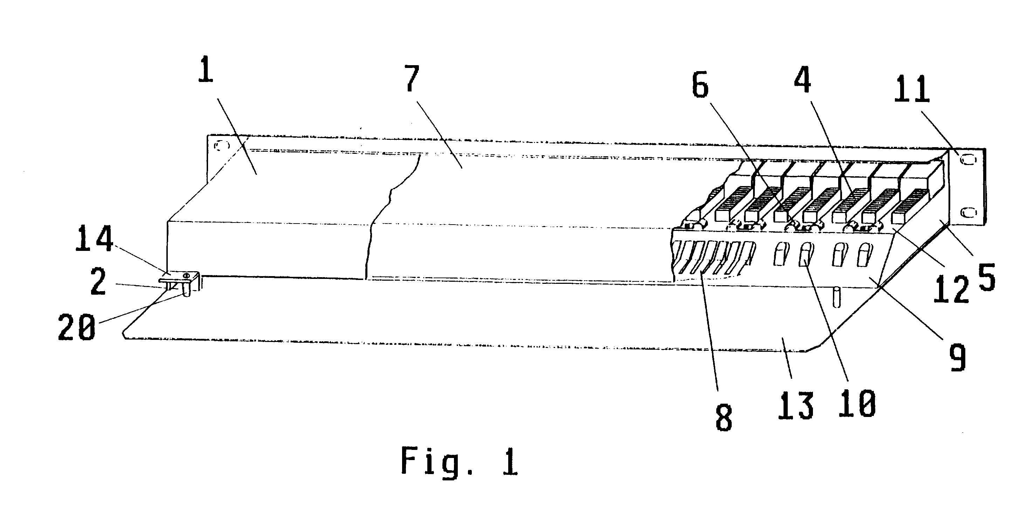

Das in Fig. 1 dargestellte Gehäuse für ein Verteilerfeld weist eine Unterplatte 13 auf, auf die ein Außengehäuse 1 aufsetzbar ist. Unterplatte 13 und Außengehäuse 1 sind mit der Frontplatte 11 verbunden, beispielsweise über eine Schraubverbindung. Am unteren Rand des Außengehäuses 1 befindet sich eine Öffnung 2, der eine Klemme 14 zugeordnet ist. Diese dient im wesentlichen der Zugentlastung eines durch die Öffnung 2 hindurchgeführten Kabels. Die Klemme 14 ist durch eine rechtwinklige Abkantung des Außengehäuses 1 gebildet, die über eine Schraubverbindung mit einem Stift 20 verschraubbar ist, der an der Unterplatte 13 befestigt ist. Durch Festschrauben der Klemme 14 über den Stift 20 wird einerseits eine Klemmung des eingeführten Kabels ereicht, andererseits erfolgt damit eine Befestigung von Außengehäuse 1 und Unterplatte 13.

Im Inneren des Außengehäuses befindet sich ein Abdeckgehäuse 7, dessen Querschnittsform im wesentlichen der Querschnittsforms des Außengehäuses folgt. Das Abdeckgehäuse deckt eine Montageplatte 5 ab, die auf der Unterplatte 13 befestigt ist. Die Montageplatte ist pultartig mit einem ebenen Bereich 12 und einem Schrägbereich 9 aufgebaut. Auf dem ebenen, mit Abstand zur Unterplatte 13 angeordneten Bereich befinden sich Klemmen 6 zur Festlegung von einzuführenden Kabel sowie die Anschlußklemmen 4 zur Befestigung der Leiter des einzuführenden Kabels. Die Anschlußklemmen 4 führen zu Buchsen, insbesondere RJ-45 Buchsen, die von der Vorderseite des Verteilerfeldes zugänglich sind.

Im Schrägbereich 9 der Montageplatte 5 sind U-förmige Stanzzungen 10 dargestellt, die nach oben unter einem spitzen Winkel zum Schrägbereich 9 der Montageplatte 5 ausgebildet sind. In ihrem vorderen Bereich sind sie abgekantet, so daß sie in diesem Bereich im wesentlichen parallel zum Schrägbereich 9 liegen.

Das Abdeckgehäuse 7 weist an der unteren, der Montageplatte 5 zugeordneten Kante eine nach innen gerichtete Abkantung auf, die kammartig gestanzt ist und auf diese Weise Kontaktfedern 8 bildet. Diese liegen im Ruhezustand auf den Stanzzungen 10 auf. Sie stehen daher in elektrischem Kontakt mit der Montageplatte 5.

Das Verteilerfeld ist zur Aufnahme von bis zu 24 Kabeln vorgesehen. Jedes Kabel wird über eine Klemme 6 befestigt und mit den Anschlußklemmen 4 verbunden. Die Kabel werden zwischen Abdeckgehäuse 7 und Montageplatte 5 hindurchgeführt, wobei die Kontaktfedern 8 auf den Kabeln zu liegen kommen. Wenn die Kabel entsprechend weit von über äußeren Isolierung befreit sind, liegen die Kontaktfedern 8 auf der Abschirmung des Kabels auf. Über die Abschirmung des Kabels wird daher ein Kontakt von Kontaktfeder 8 und Montageplatte 5 mit der Abschirmung des Kabels hergestellt.

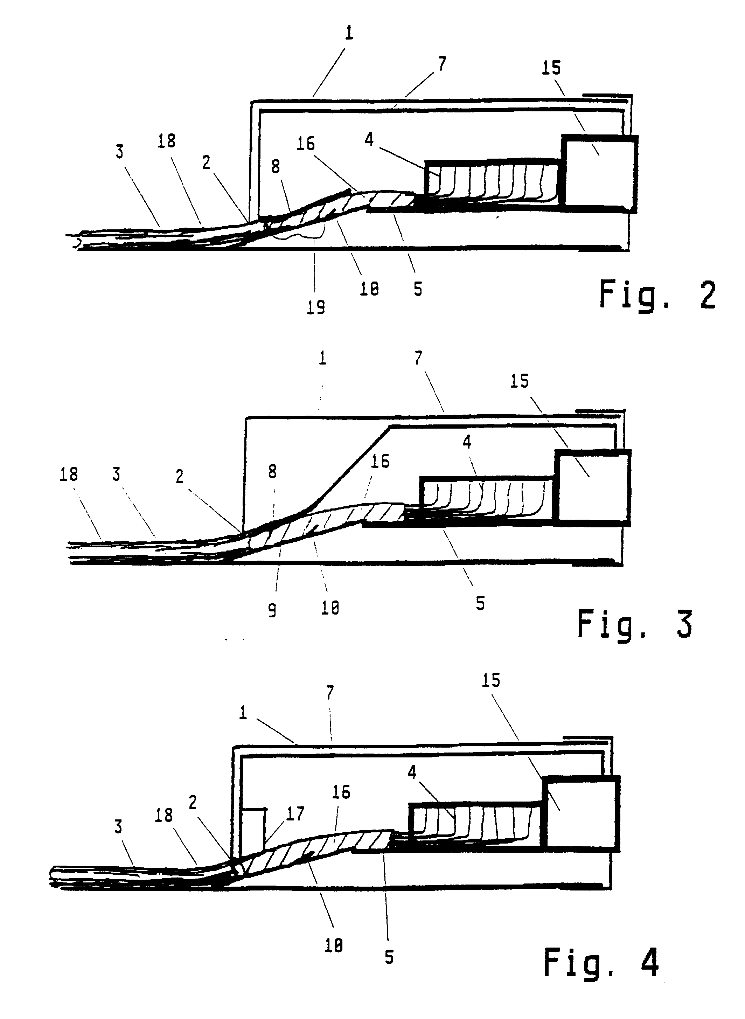

Fig. 2 zeigt eine Schnittansicht durch ein Gehäuse gemäß Figur 1. Das Kabel 3 wird von der Rückseite des Außengehäuses 1 eingeführt und über den Schrägbereich 9 an die Anschlußklemmen 4 geführt. Die Buchse 15 schließt sich unmittelbar an die Anschlußklemmen 4 an. Die Figur zeigt, wie die Kontaktfedern 8 auf der Abschirmung 16 des Kabels 3 aufliegen. Die Isolierung 18 des Kabels 3 endet innerhalb des Außengehäuses 1, so daß die Klemmung des Kabels über die Klemme 14 die Außenisolierung 18 erfaßt. Der im Kabel 3 mitgeführte Beidraht 19 ist um die Stanzzungen 10 gewickelt und wird durch den Andruck der Kontaktfedern 8 und des Kabels 3 an der Montageplatte 5 geklemmt.

Fig. 3 zeigt eine alternative Ausführungsform der Erfindung, bei der das Abdeckgehäuse in ähnlicher Weise wie die Montageplatte 5 pultförmig ausgebildet ist, wobei die Kontaktfedern 8 nach außen abgekantet sind, aber in gleicher Weise wie in Fig. 2 auf der Abschirmung 16 aufliegen. Der Vorteil dieser Ausführungsform liegt darin, daß die Gehäusegröße des Abdeckgehäuses 7 kleiner ausgebildet ist.

Fig. 4 zeigt eine weitere alternative Ausführungsform der Erfindung, bei der anstelle von abgekanteten Kontaktfedern ein mit dem Abdeckgehäuse 7 verbundener Kontaktkamm vorgesehen ist, der die Kontaktierung der Abschirmung 16 der Kabel sicherstellt. Der Abdeckkamm kann auch in Form von Metallbürsten, Federn oder einem fexiblen Flechtschlauch ausgebildet sein.

Soweit die Gehäuseteile zur Montage der Kabel nicht auseinanderzunehmen sind, sind sie vorzugsweise punktverschweißt, bzw. aus abgekanteten Blechen gebildet.

Das gesamte Verteilerfeld kann insbesondere bis zu 24 Kabel aufnehmen und ist in einem 19-Zoll-Einschub ausgebildet.

### BEZUGSZEICHENLISTE

- 1:: Außengehäuse
- 2:: Öffnung
- 3:: Kabel
- 4:: Anschlußklemme
- 5:: Montageplatte
- 6:: Klemme
- 7:: Abdeckgehäuse
- 8:: Kontaktfedern
- 9:: Schrägbereich
- 10:: Stanzzunge
- 11:: Frontplatte
- 12:: ebener Bereich
- 13:: Unterplatte
- 14:: Klemme
- 15:: Buchse
- 16:: Abschirmung
- 17:: Kontaktkamm
- 18:: Isolierung
- 19:: Beidraht
- 20:: Stift

## Patentansprüche

1. Abgeschirmtes Gehäuse für ein Verteilerfeld, mit einem Außengehäuse (1) mit Einführungsöffnungen (2) für von der Rückseite in das Gehäuse einführbare Kabel (3), die nebeneinanderliegend mit Anschlußklemmen (4) im Gehäuse verbindbar sind, wobei innerhalb des Außengehäuses (1) eine Montageplatte (5) mit Befestigungsmitteln (6) zur Befestigung der Kabel (3) und der Anschlußklemmen vorgesehen ist, und innerhalb des Außengehäuses (1) ein die Kabel (3), die Anschlußklemmen und die Montageplatte (5) abdeckendes Abdeckgehäuse (7) vorgesehen ist, wobei Abdeckgehäuse (7) und Montageplatte (5) ein im wesentlichen geschlossenes inneres Schirmgehäuse bilden und die Kabel (3) zwischen einem Rand des Abdeckgehäuses (7) und der Montageplatte (5) hindurchgeführt sind.

2. Gehäuse nach Anspruch 1, dadurch gekennzeichnet, daß das Abdeckgehäuse (7) an seinem den Kabeln (3) zugewandten Rand Kontaktfedern (8) zur Kontaktierung der freigelegten Kabelabschirmungen (16) aufweist.

3. Gehäuse nach Anspruch 2, dadurch gekennzeichnet, daß die Kontaktfedern (8) im wesentlichen parallel zur Montageplatte (5) verlaufen.

4. Gehäuse nach Anspruch 2 oder 3, dadurch gekennzeichnet, daß die Montageplatte (5) pultartig ausgebildet ist.

5. Gehäuse nach Anspruch 3 und Anspruch 4, dadurch gekennzeichnet, daß die Kontaktfedern (8) im Schrägbereich (9) der Montageplatte (5) angeordnet sind.

6. Gehäuse nach einem oder mehreren der vorhergehenden Ansprüche, dadurch gekennzeichnet, daß die Montageplatte (5) jeweils im Bereich eines aufliegenden Kabels (3) eine im spitzen Winkel von der Montageplatte (5) abstehende, gegen das Kabel gerichtete U-förmige Stanzzunge (10) aufweist, wobei die Stanzzunge (10) durch die Montage des aufliegenden Kabels in Richtung der ursprünglichen Stellung zurückgedrückt wird.

7. Verfahren zur Montage einer Reihe von abgeschirmten Kabeln (3) in einem abgeschirmten Gehäuse eines Verteilerfeldes gemäß einem der Ansprüche 1 - 6, dadurch gekennzeichnet, daß die Kabel (3) nach Entfernung Ihrer Außenisolierung (18) mittels Kabelklemmen (6) an der Montageplatte (5) befestigt werden, daß Beidrähte (19) der Kabel unter eine Stanzzunge (10) der Montageplatte (5) geklemmt werden, daß das Abdeckgehäuse (7) auf die Montageplatte (5) und die Kabel (3) aufgesetzt wird, wobei Kontaktfedern (8) an die Abschirmung (16) der abisolierten Kabel (3) zur Anlage kommen und daß schließlich das Außengehäuse (1) auf das Abdeckgehäuse (7) aufgesetzt und befestigt wird.

## Claims

1. A shielded casing for a distribution assembly comprising an outer casing (1) with insertion openings (2) for cables (3) which can be inserted in the casing from the rear and, lying adjacent one another, can be connected to terminals (4) in the casing wherein a mounting plate (5) with means (6) for attaching the cables (3) and terminals is provided inside the outer casing (1), wherein a covering casing (7) covering the cables (3), the terminals and the mounting plate (5) is provided inside the outer casing (1), and wherein the covering casing (7) and mounting plate (5) form a substantially closed internal screening casing, and the cables (3) are taken through between an edge ofthe covering casing (7) and the mounting plate (5).

2. A casing according to claim 1, characterised in that the edge ofthe covering casing (7) facing towards the cables (3) has contact springs (8) for contacting the exposed cable screens (16).

3. A casing according to claim 2, characterised in that the contact springs (8) extend substantially parallel with the mounting plate (5).

4. A casing according to claim 2 or 3, characterised in that the mounting plate (5) has a desk-like structure.

5. A casing according to claims 3 and 4, characterised in that the contact springs (8) are arranged in the inclined section (9) ofthe plate (5).

6. A casing according to one or more ofthe preceding claims, characterised in that the mounting plate (5) has a U-shaped punched tab (10) in the vicinity of each overlying cable (3), which tab (10) projects from the plate (5) at an acute angle and is directed towards the cable. the punched tab (10) being pressed back in the direction ofthe original position by the mounting ofthe overlying cable.

7. A method of mounting a row of screened cables (3) in a shielded casing of a distribution assembly according to any of claims 1 to 6, characterised in that the cables (3) are attached to the mounting plate (5) by cable clamps (6) after removal oftheir external insulation (18), that sheath wires (19) of the cables are clamped below a punched tab (10) of the plate (5), that the covering casing (7) is placed on the plate (5) and cables (3), with contact springs (8) resting on the screen (16) ofthe bared cables (3), and that the outer casing (1) is finally placed and fixed on the covering casing (7).

## Revendications

1. Boîtier blindé pour un panneau de distribution, comportant un boîtier extérieur (1) pourvu d'ouvertures d'introduction (2) pour des câbles (3) qui sont aptes à être introduits dans le boîtier par le côté arrière et qui sont aptes à être reliés, les uns à côté des autres, à des bornes de connexion (4) situées dans le boîtier, étant précisé qu'il est prévu, à l'intérieur du boîtier extérieur (1), une plaque de montage (5) pourvue de moyens de fixation (6) pour la fixation des câbles (3) et des bornes de connexion, et qu'il est prévu, à l'intérieur du boîtier extérieur (1), un boîtier de recouvrement (7) qui recouvre les câbles (3), les bornes de connexion et la plaque de montage (5), le boîtier de recouvrement (7) et la plaque de montage (5) formant un boîtier de blindage intérieur globalement fermé et les câbles (3) passant entre un bord du boîtier de recouvrement (7) et la plaque de montage (5).

2. Boîtier selon la revendication 1, caractérisé en ce que le boîtier de recouvrement (7) comporte, sur son bord tourné vers les câbles (3), des ressorts de contact (8) destinés à établir un contact avec les blindages de câbles (16) découverts.

3. Boîtier selon la revendication 2, caractérisé en ce que les ressorts de contact (8) sont globalement parallèles à la plaque de montage (5).

4. Boîtier selon la revendication 2 ou 3, caractérisé en ce que la plaque de montage (5) a la forme d'un pupitre.

5. Boîtier selon les revendications 3 et 4, caractérisé en ce que les ressorts de contact (8) sont disposés dans la zone inclinée (9) de la plaque de montage (5).

6. Boîtier selon l'une au moins des revendications précédentes, caractérisé en ce que la plaque de montage (5) comporte, dans la zone de chaque câble (3) posé, une languette découpée en U (10) espacée de la plaque de montage (5) suivant un angle aigu et dirigée vers le câble, cette languette découpée (10) étant repoussée vers sa position initiale par le montage du câble posé.

7. Procédé pour le montage d'une série de câbles blindés (3) dans un boîtier blindé d'un panneau de distribution selon l'une des revendications 1 à 6, caractérisé en ce que les câbles (3), une fois que leur isolation extérieure (18) a été enlevée, sont fixés à la plaque de montage (5) à l'aide de serre-câbles (6), en ce que des fils supplémentaires (19) des câbles sont serrés sous une languette découpée (10) de la plaque de montage (5), en ce que le boîtier de recouvrement (7) est posé sur la plaque de montage (5) et sur les câbles (3), moyennant quoi des ressorts de contact (8) viennent s'appliquer contre le blindage (16) des câbles dénudés (3), et en ce que le boîtier extérieur (1) est enfin posé et fixé sur le boîtier de recouvrement (7).
